# EUROPÄISCHE PATENTSCHRIFT

(11) **EP 0 669 795 B1**
(45) Veröffentlichungstag und Bekanntmachung des Hinweises auf die Patenterteilung: **06.10.1999**
(21) Anmeldenummer: 95102292.0
(22) Anmeldetag: 17.02.1995
(51) Int. Cl.: H05K 7/14, H04M 1/02

(54) **Gehäuse zur Aufnahme von bestückten Leiterplatten**
Enclosure for housing boards with components
Boîtier pour loger des plaquettes de circuit imprimés pourvus de composants

(30) Priorität: 25.02.1994 DE 9403212 U
(43) Veröffentlichungstag der Anmeldung: 30.08.1995
(73) Patentinhaber: SIEMENS AKTIENGESELLSCHAFT, 80333 München (DE)
(72) Erfinder: Verding, Markus, Dipl.-Ing., D-46286 Dorsten (DE); Ehm, Thomas, Dipl.-Ing., D-44265 Dortmund (DE)

(56) Entgegenhaltungen:
- DE-U- 7 526 707
- GB-A- 2 256 540
- US-A- 3 668 476

## Beschreibung

Die Erfindung betrifft ein Gehäuse zur Aufnahme von bestückten Leiterplatten, welches mit einem offen zugänglichen Bereich versehen ist, der mit einer Abdeckhaube abschließbar ist, insbesondere zur Aufnahme von Leiterplatten, deren Bestückung zumindest Teile eines Kommunikationssystems bildet und wobei mehrere Leiterplatten parallel zueinander in das Gehäuse einzubringen sind.

Ein derartiges Gehäuse zur Aufnahme von bestückten Leiterplatten ist z. B. aus dem Dokument US-A-3 668 470 bekannt. Es ist üblich, in ein Gehäuse, das mehrere Leiterplatten aufnehmen soll diese Leiterplatten stehend nebeneinander in entsprechenden Führungsrillen einzuschieben. Für den Anschluß von Leitungszuführungen und für den elektrischen Anschluß untereinander sind die Leiterplatten mit Steckvorrichtungen versehen, die an der in Einschubrichtung vorderen Kante angeordnet sind und mit an der Rückwand vorhandenen Gegensteckern kontaktieren. Eine solche Anordnung zur Aufnahme von Leiterplatten in einem Gehäuse ist dann sinnvoll, wenn diese Leiterplatten angenähert die gleiche Größe aufweisen und das Gehäuse für sich eine größere Einheit darstellt. Die Anschlußteile der Leiterplatten befinden sich demnach im Gehäuseinneren, so daß auch bei einer nur teilweisen Bestückung die Gegensteckereinheiten bereits hinsichtlich des möglichen Gesamtaufbaus vorgegeben sein müssen. Es ist auch bekannt, insbesondere in den Fällen, in denen Funktionsergänzungen vorgenommen werden sollen entsprechende größenmäßig angepaßte Leiterplatten zusätzlich auf eine Hauptleiterplatte über Steckverbinder bedarfsweise aufzustecken. Dies setzt auch ein entsprechend großes Gehäuse voraus.

Es ist die Aufgabe der vorliegenden Erfindung, eine flexible, bestimmungsorientierte Anordnung von bestückten Leiterplatten in einem Gehäuse zu ermöglichen.

Dies wird dadurch gelöst, daß das Gehäuse mit Ausnahme einer Einschuböffnung einen Rahmen bildenden Randbereich aufweist, daß eine erste Leiterplatte auf einer von der Rückwand beabstandeten und aus mit dieser verbundenen Stützteilen gebildeten Auflage auflegbar ist und in diesem Zustand angenähert parallel zur Rückwand lagegesichert fixierbar ist, daß in den Raum zwischen der ersten Leiterplatte und der Rückwand (21) mindestens eine zweite Leiterplatte in entsprechende, mit der Rückwand ganzteilig verbundene und im Bereich des seitlichen Leiterplattenrandes angreifende Halterungs- und Führungselemente frei zugänglich durch die Einschuböffnung einschiebbar ist.

Die Leiterplatten werden also in zwei Ebenen in unterschiedlicher Weise gelagert und gehaltert. Es können Leiterplatten unterschiedlicher Größe eingebracht werden. Bei entsprechender Anordnung der Halterungs- und Führungselemente an der Rückwand sind mehrere Leiterplatten nebeneinander einschiebbar. Diese von vornherein oder bedarfsweise einzuschiebenden Leiterplatten können optional vorgegebenen Funktionen zugeordnet sein. Je nach ihren Größenabmessungen werden sie in einfacher Weise durch die Führungs- und Halterungselemente beim Einschiebevorgang in eine Endlage geführt. Das Einschieben von Leiterplatten an der Rückwand kann auch problemlos bei weiterhin aufliegender erster Leiterplatte erfolgen. Das bedeutet, daß auch die, diese Leiterplatte überdeckende Abdeckhaube hierzu nicht entfernt werden muß. Eine derartige Anordnung von Leiterplatten mit unterschiedlichen Befestigungsarten bietet Vorteile für den Service und es ergibt sich dadurch gleichzeitig eine größere Gestaltungsfreiheit für das Gehäuse. Es ist beispielsweise möglich, in den Fällen, in denen der Bereich für die aufzulegende erste Leiterplatte größer als der Bereich ist, in den die mindestens zweite Leiterplatte einzuschieben ist für das Gehäuse einen Monitor-ähnlichen Charakter zu schaffen. Dies kann beispielsweise durch einen entsprechenden Hinterschnitt erfolgen. Gemäß einer weiteren Ausbildung der Erfindung sind an dem in der Einschubrichtung hinteren Randbereich einer mindestens zweiten einschiebbaren Leiterplatte und an dem damit benachbarten Randbereich der aufgelegten ersten Leiterplatte sowohl die für externe Anschlüsse als auch für die elektrische Verbindung der einzelnen Leiterplatten untereinander notwendigen Teile von Steckverbindern angeordnet. Bei einem Standgehäuse oder bei einem in der Gebrauchslage als Wandgehäuse benutzten Gehäuse kann also in einfacher Weise der Zugriff zu den Anschlußbereichen erfolgen. Im Bedarfsfall notwendige Änderungen sind also problemlos durchzuführen.

Gemäß einer Weiterbildung der Erfindung sind die Stützteile mit Ausnahme der für das Einschieben der mindestens zweiten unteren Leiterplatte zugänglichen Seite als Rahmen, der gleichzeitig die entsprechenden Seitenwände des Gehäuses mitbildet ausgestaltet. Dieser Rahmen kann einen stufenförmig ausgebildeten Randbereich aufweisen, so daß dann gleichzeitig eine Begrenzung für die aufzulegende erste Leiterplatte vorgegeben ist. Durch die gewählte Kontur des Rahmens ist erfindungsgemäß ein Randbereich - bei einem als Wandgehäuse benutzten Gehäuse ist dies der untere Randbereich - an dem die Anschlußelemente angeordnet sind, frei zugänglich.

Gemäß einer Weiterbildung der Erfindung ist die aufzulegende erste Leiterplatte dadurch in einfacher Weise aufzubringen und zu haltern, daß an einem Randbereich des vorgesehenen Rahmens eine Aufnahme für den Plattenrand bzw. für die Kante einer Seite dieser Leiterplatte gebildet ist und an den Plattenrand mindestens einer anderen Seite dieser aufzulegenden Leiterplatte zur sicheren Fixierung bzw. Halterung ein Verriegelungselement nach dem erfolgten Auflegen dieser Leiterplatte automatisch verriegelnd angreift. Dieses Verriegelungselement besteht in einfacher Weise aus einem beim Auflegen dieser ersten Leiterplatte ausgelenkten federnden Steg, der nach dem erfolgten Auflegen der Leiterplatte mit der Rückkehr in seine Ausgangslage dem Plattenrand verriegelnd übergreift. Dieser federnde Steg ist aus einem vorzugsweise im Eckbereich des den genannten Aufnahmen gegenüberliegenden Plattenrandes senkrecht zur Leiterplattenebene stehenden Wandteils freigeschnitten und weist bestimmungsgemäß mit seinem freien Ende in Richtung der als Auflage dienenden Rahmenwandung für die erste Leiterplatte.

Zur Bildung einer partiellen Führungsnut, in die zunächst der Plattenrand der aufzulegenden Leiterplatte eingeführt wird, sind am genannten Rahmen angenähert senkrecht zur Plattenebene stehende Nasen angebracht, die zum freien Ende hin jeweils einen mit einer Einlaufschräge versehenen Einschnitt zur Einbringung des Plattenrandbereiches aufweisen.

Um eine aufgelegte Leiterplatte, insbesondere bei einem Wandgehäuse problemlos entnehmen zu können, greift im Bereich der Verriegelungsstelle eine Gegenfeder im Sinne einer Abhebebewegung für die Leiterplatte von unten an die aufgelegte Leiterplatte an. Nach einer vorgenommenen Entriegelung bewegt sich demnach die Leiterplatte nach außen.

Gemäß einer weiteren Ausbildung der Erfindung sind die Führungselemente für die einzuschiebende untere mindestens zweite Leiterplatte direkt an der Rückwandplatte ausgebildet. Mit Erreichen der definierten Endlage wird die jeweilige Leiterplatte durch ein Verriegelungselement gesichert fixiert. Dieses Verriegelungselement kann einen aus der Rückwandplatte freigeschnittenen federnden Steg mit einer an seinem freien Ende angesetzen Nase darstellen. Er wird beim Einschieben der unteren Leiterplatte zunächst ausgelenkt und es wird in der Endlage der Leiterplatte durch ihn mit seiner Rückkehr in seine Ausgangslage die Leiterplatte gesichert fixiert.

Weitere vorteilhafte Ausgestaltungen der Erfindung sind den restlichen Unteransprüchen sowie der Figurenbeschreibung zu entnehmen.

Die Erfindung soll im folgenden anhand eines Ausführungsbeispiels näher erläutert werden. Es zeigt
- Fig.: 1 eine Draufsicht auf ein Gehäuse bei abgenommener Abdeckhaube
- Fig. 2 und Fig. 3: eine jeweils teilweise geschnittene Seitenansicht
- Fig. 4: eine vergrößerte Ansicht des Sektors A aus der Fig. 2
- Fig. 5: eine vergrößerte Ansicht des Sektors B aus der Fig. 1
- Fig. 6: eine vergrößerte Ansicht des Sektors C aus der Fig. 3
- Fig. 7: eine vergrößerte Darstellung der Verriegelungsstelle.

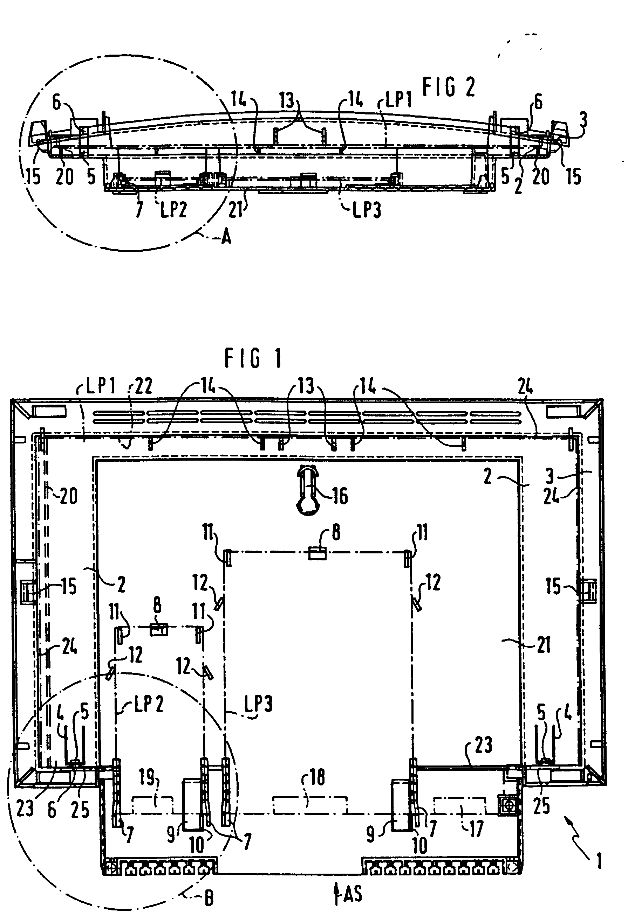

Die Fig. 1 zeigt eine Draufsicht eines mittels des Langloches 16 unter Verwendung einer entsprechenden Aufhängevorrichtung an einer Wand zu befestigenden Gehäuses. In diesem Gehäuse können schematisch durch strichpunktierte Umrißlinien angedeutete Leiterplatten LP1 bis LP3 angeordnet werden. Dieses Wandgehäuse 1 kann beispielsweise Leiterplatten aufnehmen durch deren Bestückung ein Kommunikationssystem realisiert wird. Das Gehäuse ist für ein Kommunikationssystem vorgesehen, das naturgemäß nur eine geringere Anzahl von Kommunikationsanschlüssen aufweisen wird.

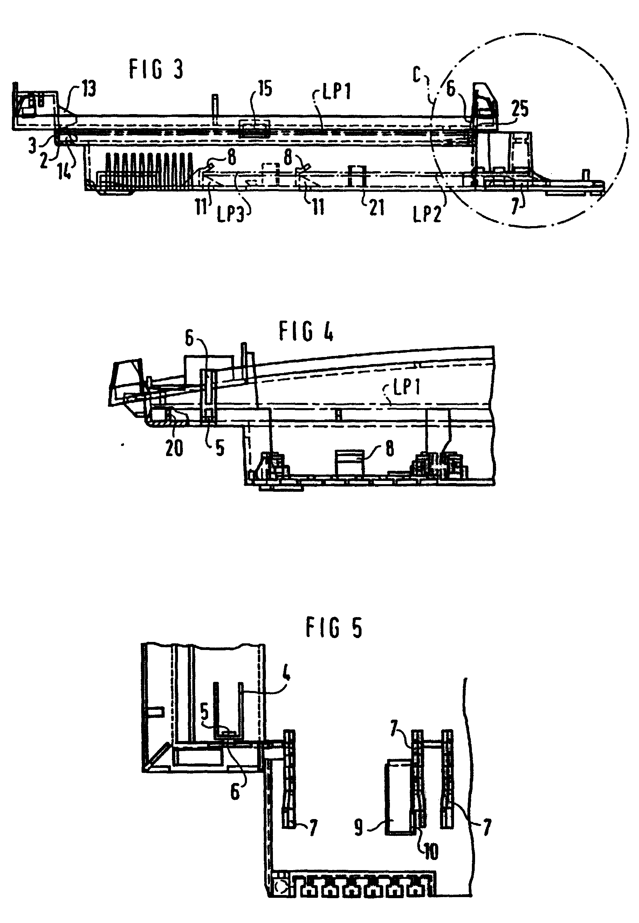

Wie den Figuren 1 und 2 zu entnehmen ist, weist das Gehäuse mit Ausnahme der Anschlußseite AS einen rahmenartigen Randbereich auf, der als gestufte Kontur 2, 3 sowohl eine Auflagefläche 2 für eine erste Leiterplatte LP1 als auch eine entsprechende formmäßige Begrenzung für diese Leiterplatte darstellt. Die Leiterplatte LP1, die beispielsweise alle oder die auch nur die wesentlichsten Komponenten eines Kommunikationssystems trägt, wird auf diesen an drei Begrenzungsseiten vorhandenen Rahmen ein- bzw. aufgelegt. Hierzu sind an einem Randbereich, bezogen auf die Verwendung als Wandgehäuse der obere Randbereich des Rahmens eine Aufnahme für den Plattenrand 22 vorgesehen. Sie besteht aus mehreren über diese Rahmenbreite verteilt angeordneten Ansätzen 14 bzw. 13, die an ihrem freien Ende jeweils eine Einlaufschräge aufweisen und mit ihren einander zugewandten Begrenzungskanten einen minimalen Abstand aufweisen, der in etwa der Dickenabmessung der Leiterplatte LP1 entspricht. Die Ansätze 13 sind an der senkrecht zur Auflagefläche 2 stehenden Teilwandfläche 24 der rahmenartigen Kontur angebracht während die seitlich davon beabstandeten Ansätze 14 an der oberen Rahmenfläche vorhanden sind. Um die Leiterplatte LP 1 in das Gehäuse einzubringen wird zunächst der obere Plattenrand 22 dieser Leiterplatte in die durch die Einlaufschräge in diese genannten Ansätze gebildete Öffnung bis zum rückwärtigen Anschlag eingeschoben und zur Rahmenfläche hin bewegt bis sie daran aufliegt. Es ist nicht erforderlich, daß die Leiterplatte unmittelbar auf der Auflagefläche 2 aufliegt, sondern es kann hierfür ein sinnvoller Weise parallel zur Seitenwandfläche 24 verlaufender Steg 20 vorgesehen sein. Somit ist die Leiterplatte auch in dem Bereich bestückbar, der sich mit der Teilfläche 2 des Rahmens überlappt.

Bei der zum Auflegen der Leiterplatte notwendigen Abwärtsbewegung wird ein federnder Steg 6, der aus einem senkrecht zur Rahmenfläche 2 stehenden Wandteil 25 freigeschnitten ist, durch den Plattenrand zunächst hinweggedrückt und übergreift nach dem Auflegen auf die Rahmenfläche 2 mit der dadurch freigegebenen Rückkehrmöglichkeit in seine ursprüngliche Lage den Plattenrand. Dies erfolgt, wie den Figuren 1 bis 3 zu entnehmen ist, an den beiden Eckbereichen des Gehäuses bzw. der Rahmenkontur. Es wird also damit die aufgelegte Leiterplatte automatisch durch die Wirkung dieses federnden und als Verriegelungsfeder dienenden Steges verriegelt. Die im Wandgehäuse stehend angeordnete Leiterplatte wird somit an einer Bewegung nach vorne gehindert.

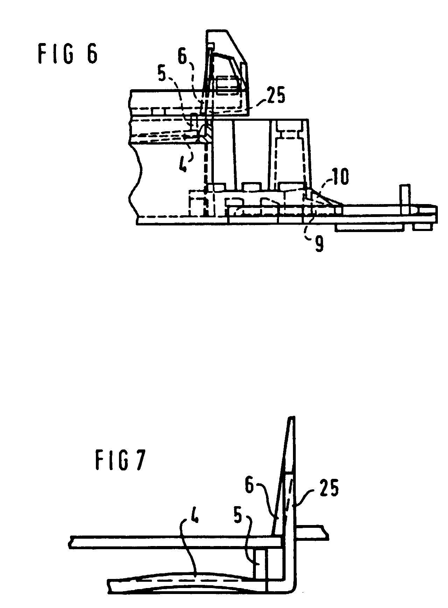

Wie den Figuren 1 bis 3 und insbesondere der vergrößerten Darstellung des Sektors C gemäß der Fig. 6 zu entnehmen ist, befindet sich in unmittelbarer Nähe des federnden Steges 6 in der Teilfläche 2 der rahmenartigen Kontur eine freigeschnittene Feder 4. Diese durch den Freischnitt in der Teilfläche 2 gebildete Feder hat einen rechtwinklig zu ihrer Längsachse verlaufenden und auf die aufzulegende Leiterplatte gerichteten Ansatz 5. Mit diesem Ansatz drückt dann die, mit dem Auflegen der Leiterplatte vorgespannte Feder 4 an die Leiterplatte. Diese Leiterplatte wird im aufgelegten Zustand, wie bereits geschildert, durch die Feder 6 verriegelt, da diese nach ihrer Auslenkung und der Rückkehr in die Ausgangslage den Plattenrand übergreift. Dies ist in dem in der Fig. 7 dargestellten Ausschnitt gezeigt. Durch die Feder 4 wird nach der durch das Niederdrücken der Verriegelungsfeder 6 erfolgenden Entriegelung die Leiterplatte LP1 nach vorne bewegt. Dadurch kann sie problemlos abgehoben werden. Die Anordnung der Gegenfeder 4 im Eckbereich der durch die rahmenartige Kontur gebildeten Auflagefläche ist auch der Fig. 5 zu entnehmen.

Um die aufzulegende Leiterplatte LP1 nahezu in ihrer Gesamtbreite für die Leiterbahnen und die Bestückungselemente nutzen zu können, ist vorgesehen, daß sie nicht unmittelbar auf der durch die Teilfläche 2 gebildeten Gehäusestufe aufliegt, sondern es ist hierfür ein zu dieser Fläche senkrecht stehender Steg 20 vorhanden. Ein solcher Steg, der auch durch einzelne Stützelemente der gleichen Höhe ersetzt werden könnte, ist bei der Anwendung der für die Aufnahme der Plattenkante vorgesehenen Ansätze 14 notwendig. Die maximale Höhe dieser Ansätze 14 und des Steges 20 stimmen überein. Die obere und die jeweils seitliche Begrenzung für die aufzulegende Leiterplatte wird für das parallel zum Steg bzw. senkrecht zur Auflagefläche 2 verlaufende Wandteil 24 der rahmenartigen Kontur gebildet. Wie insbesondere der Figur 2 und auch der Figur 1 zu entnehmen ist, hat der die eigentliche Auflagefläche des Wandgehäuses 1 bildende Teil der Rückwand 21 eine geringere Breite, als der die Leiterplatte LP1 aufnehmende Bereich. Eine solche grundsätzlich z-förmige Gestaltung der Randbereiche - mit der Ausnahme der Anschlußseite AS - ergibt als Gestaltungsprinzip für dieses Gehäuse einen monitorartigen Charakter.
Es besteht nun die Möglichkeit, neben dieser Hauptleiterplatte LP1 mindestens eine weitere Leiterplatte auch ohne Entfernen dieser Leiterplatte LP1 anzubringen. Im Ausführungsbeispiel sollen noch zwei weitere Leiterplatten, nämlich die Leiterplatte LP2 und die Leiterplatte LP3, die in den Figuren 1 bis 4 jeweils durch die strichpunktierte Linie angedeutet sind, eingebracht werden. An der Rückwandplatte sind Führungselemente 7 angeordnet, in die die jeweilige Leiterplatte beispielsweise LP2 in unmittelbarer Nähe der Rückwand auch bei vorhandener Leiterplatte LP1 eingeschoben werden kann. Diese Führungselemente 7 sind bei einem Spritzgußkunststoffgehäuse unmittelbar einstückig mit der Rückwand 21 des Gehäuses 1 verbunden. Durch diese Führungselemente 7 wird für den seitlichen Plattenrand eine Führungsnut gebildet, die das gezielte Einschieben der Leiterplatte ermöglicht. Sie sind, wie der Figur 1 zu entnehmen ist, bezogen auf die Länge der Leiterplatte nur partiell vorgesehen. Bei der Einschiebebewegung wird die Leiterplatte durch die beidseitig vorgesehenen Stege 12 zusätzlich geführt. Ihre Endlage wird durch den unmittelbar an der Rückwand ausgebildeten Zapfen 8 bestimmt, der wie aus der Figur 3 zu entsehen ist, durch seine spezielle Ausformung des freien Endes eine gewisse Einlaufmöglichkeit bietet. Die ungefähr in Leiterplattenbreite beabstandeten Ansätze 11 weisen, wie aus der Figur 3 ersichtlich, eine Auflaufschräge für die einzuschiebende Leiterplatte, beispielsweise die Leiterplatte LP2 auf. Durch die Ansätze 8 und 11 wird also die Leiterplatte in eine Zwangsendlage geführt. Zur Lagesicherung der eingeschobenen Leiterplatte ist eine Verriegelungsfeder 9 vorhanden. Diese besteht aus einem aus der Rückwandplatte freigeschnittenen federnden Steg. Dieser steht in der nicht gespannten Lage etwas aus der Rückwandebene nach vorne und wird aufgrund der an ihm angeordneten Nase 10 nach hinten ausgelenkt. Ist die Leiterplatte bis zum Anschlag eingeschoben, dann kehrt dieser Steg in die Ruhelage zurück. Durch die mit ihrer Vorderkante am Leiterplattenrand anliegende Nase 10 des federnden Steges 9 wird somit die eingeschobene Leiterplatte lagegesichert fixiert. Es ist grundsätzlich möglich, Leiterplatten nicht nur nebeneinander in den Schrägen der Führungselemente einzuschieben, sondern in gleicher Weise über einer solchen Leiterplatte eine weitere Leiterplatte bei entsprechend ausgebildeten Führungs- und Verriegelungselementen einzubringen. Im Ausführungsbeispiel werden lediglich zwei Leiterplatten nebeneinander in der geschilderten Weise an der Rückwand gelagert. Die mindestens in einer zweiten Ebene einzuschiebenden Leiterplatten LP2 und LP3 können in gleicher Weise wie die ein- bzw. aufgelegte Leiterplatte LP1 aufgrund ihrer Bestückung für grundsätzliche Funktionen der Funktionseinheit, die das Gehäuse 1 aufnimmt, eingesetzt werden. Sie können aber auch beispielsweise bei einem Kommunikationssystem Funktionen zugeordnet werden, die optional für das System vorgesehen sind.

Die Rahmenstruktur des Gehäuses 1 ist an der Anschlußseite AS unterbrochen. Die unteren Plattenrandbereiche bei einem Wandgehäuse der eingebrachten Leiterplatten sind damit frei zugänglich. An diesen Randbereichen können Steckelemente angedeutet durch die Steckelemente 17 bis 19 angebracht sein. Durch die entsprechenden Steckverbinder können die einzelnen Leiterplatten untereinander verbunden werden oder es können dadurch einzelne Versorgungs- bzw. Anschlußleitungen angeschlossen werden.

Das Gehäuse kann in nicht dargestellter Weise mit einer Abdeckhaube geschlossen werden. Hierzu könnte diese Haube federnde Rasthaken aufweisen, die beim Zusammenfügen mit dem Gehäuseteil 1 in die Ausnehmung 15 des jeweils seitlichen Gehäuserandes eingeführt werden. Sie greifen dabei in eine Gegenraste ein. Dies kann beispielsweise dadurch erfolgen, daß der zunächst ausgelenkte Rasthaken mit der Rückkehr in seine Ausgangslage in dem äußeren Randbereich die Gehäusewand hinterschnappt. Nach dem Entriegeln und Abheben der Abdeckhaube sind die Anschlußelemente an dem unteren Plattenrand problemlos zugänglich.

## Patentansprüche

1. Gehäuse zur Aufnahme von bestückten Leiterplatten, welches mit einem offen zugänglichen Bereich versehen ist, der mit einer Abdeckhaube abschließbar ist, insbesondere zur Aufnahme von Leiterplatten, deren Bestückung zumindest Teile eines Kommunikationssystems bildet und wobei mehrere Leiterplatten parallel zueinander in das Gehäuse einzubringen sind,
**dadurch gekennzeichnet,**
daß das Gehäuse mit Ausnahme einer Einschuböffnung einen Rahmen bildenden Randbereich aufweist, daß eine erste Leiterplatte (LP1) auf einer von der Rückwand beabstandeten und aus mit dieser verbundenen Stützteilen gebildeten Auflage auflegbar ist und in diesem Zustand angenähert parallel zur Rückwand lagegesichert fixierbar ist, daß in den Raum zwischen der ersten Leiterplatte (LP1) und der Rückwand (21) mindestens eine zweite Leiterplatte (LP2) in entsprechende, mit der Rückwand ganzteilig verbundene und im Bereich des seitlichen Leiterplattenrandes angreifende Halterungs- und Führungselemente (7, 8, 11, 12, 9) frei zugänglich durch die Einschuböffnung einschiebbar ist.

2. Gehäuse nach Anspruch 1,
**dadurch gekennzeichnet,**
daß an dem in Einschubrichtung hinteren Randbereich einer mindestens zweiten einschiebbaren Leiterplatte (LP2) und an dem damit unmittelbar benachbarten Randbereich der ein- bzw. aufgelegten ersten Leiterplatte (LP1) sowohl die für externe Anschlüsse, als auch für die elektrische Verbindung der einzelnen Leiterplatten untereinander notwendigen Teile (17, 19) von Steckverbindern angeordnet sind.

3. Gehäuse nach Anspruch 1,
**dadurch gekennzeichnet,**
daß die Stützteile mit Ausnahme der für das Einschieben der mindestens zweiten unteren Leiterplatte (LP2), vorhandenen Einschuböffnung mittelbar oder unmittelbar als der Rahmen, der gleichzeitig entsprechende Seitenwände (2, 24) des Gehäuses mitbildet, ausgestaltet sind.

4. Gehäuse nach Anspruch 3,
**dadurch gekennzeichnet,**
daß Flächenteile (2, 24, 3) des Rahmens einen an die Abmessungen der ersten oberen Leiterplatte (LP1) angepaßten Randbereich für die aufzulegende Leiterplatte (LP1) stufenförmig begrenzen.

5. Gehäuse nach Anspruch 3,
**dadurch gekennzeichnet,**
daß die erste Leiterplatte (LP1) an einen an der Teilfläche (2) des Rahmens angesetzten Steg (20) aufliegt.

6. Gehäuse nach einem der Ansprüche 3 bis 5,
**dadurch gekennzeichnet,**
daß an einem Randbereich des Rahmens eine Aufnahme für den Plattenrand (22) einer Seite der ersten Leiterplatte (LP1) gebildet ist und an den Plattenrand mindestens einer anderen Seite dieser ersten Leiterplatte (LP1) zur sicheren Fixierung ein Verriegelungselement (6) nach dem erfolgten Auflegen dieser Leiterplatte automatisch verriegelnd angreift.

7. Gehäuse nach Anspruch 6,
**dadurch gekennzeichnet,**
daß die Aufnahme durch mehrere am Rahmen angenähert senkrecht zur Plattenebene angebrachte Nasen (13, 14) besteht, die zum freien Ende hin einen mit einer Einlaufschräge versehenen Einschnitt zur Einführung des Plattenrandbereiches (22) aufweisen.

8. Gehäuse nach Anspruch 6,
**dadurch gekennzeichnet,**
daß das Verriegelungselement aus einem beim Auflegen der ersten Leiterplatte (LP1) ausgelenkten federnden Steg (6) besteht, der nach dem erfolgten Auflegen der Leiterplatte (LP1) mit der Rückkehr in seine Ausgangslage den Plattenrand verriegelnd übergreift (Fig. 7).

9. Gehäuse nach Anspruch 8,
**dadurch gekennzeichnet,**
daß der federnde Steg (6) aus einem senkrecht zur Leiterplattenebene stehenden Wandteil (25) freigeschnitten ist und mit seinem freien Ende in Richtung der Auflage für die erste Leiterplatte (LP1) weist.

10. Gehäuse nach einem der Ansprüche 6 bis 9,
**dadurch gekennzeichnet,**
daß im Bereich der Verriegelungsstelle eine Gegenfeder (4, 5) im Sinne einer Abhebebewegung an der aufgelegten ersten Leiterplatte (LP1) angreift.

11. Gehäuse nach Anspruch 10,
**dadurch gekennzeichnet,**
daß die Gegenfeder ein aus der Teilfläche (2) des Rahmens (2, 24, 3) herausgeschnittener federnder Steg (4) ist, der im ausgelenkten Zustand mit an seinem freien Ende angenähert rechtwinklig zu seiner Längsachse verlaufenden und auf die Leiterplatte gerichteten Ansatz (5) eine Andruckkraft auf diese Leiterplatte (LP1) ausübt.

12. Gehäuse nach Anspruch 1,
**dadurch gekennzeichnet,**
daß die Führungselemente für die einzuschiebende untere mindestens zweite Leiterplatte (LP2) durch mit der Rückwandplatte (21) verbundene Stege (7) gebildet sind, die zumindest teilweise eine schlitzartige Aufnahme für die in Einschieberichtung verlaufende Leiterplattenrandbereiche aufweisen, daß ein in Einschieberichtung vorderen Führungssteg (8) die Endlage der einzuschiebenden unteren Leiterplatte (LP2, LP3) definiert, daß ein Verriegelungselement (9) in der Endlage der jeweiligen unteren Leiterplatte diese im vorderen Randbereich gesichert fixiert.

13. Gehäuse nach Anspruch 12,
**dadurch gekennzeichnet,**
daß das Verriegelungselement einen aus der Rückwandplatte (21) freigeschnittenen federnden Steg (9) darstellt, der während des Einschiebens der unteren Leiterplatte (LP2) ausgelenkt und in der Endlage der Leiterplatte mit seiner Rückkehr in seine Ausgangslage diese Leiterplatte in der Endlage gesichert fixiert.

14. Gehäuse nach Anspruch 1,
**dadurch gekennzeichnet,**
daß mit der Rückwandplatte verbundene Halterungs- (9) und Führungselemente (7, 8, 11, 12) derart angeordnet sind, daß mindestens zwei untere Leiterplatten (LP2, LP3) zur nebeneinander erfolgenden Lagerung einschiebbar sind.

15. Gehäuse nach Anspruch 14,
**dadurch gekennzeichnet,**
daß die einschiebbaren unteren Leiterplatten (LP2, LP3) in ihrer Bestückung für die Realisierung zusätzlicher optional einzusetzender Funktionen verwendet werden.

16. Gehäuse nach den Ansprüchen 1 und 2,
**dadurch gekennzeichnet,**
daß die Abdeckhaube aus einem ersten Haubenteil, das im aufgesetzten Zustand den in Einschieberichtung der mindestens zweiten Leiterplatte (LP2) hinteren Randbereich sowie den damit benachbarten Randbereich der ersten Leiterplatte (LP1) frei zugänglich läßt, und aus einem diesen genannten Bereich nach dem Aufsetzen überdeckenden zweiten Haubenteil gebildet wird.

17. Gehäuse nach einem der vorhergehenden Ansprüche,
**dadurch gekennzeichnet,**
daß es als Wandgehäuse verwendet wird.

18. Gehäuse nach Anspruch 17,
**dadurch gekennzeichnet,**
daß die Verriegelungselemente (6, 9) sowohl für die erste Leiterplatte (LP1) als auch für jede der anderen an der Rückwandplatte gelagerten Leiterplatten (LP2, LP3) derart positioniert sind, daß sie jeweils am unteren Leiterplattenrand angreifen.

19. Gehäuse nach einem der vorhergehenden Ansprüche,
**dadurch gekennzeichnet,**
daß es einschließlich der an ihm als Bestandteile einstückig ausgebildeten Halterungs- Führungs- und Verriegelungselemente als Kunststoffspritzteil hergestellt ist.

## Claims

1. Housing for receiving populated printed circuit boards, which is provided with an openly accessible region that can be closed off with a covering hood, in particular for receiving printed circuit boards whose mounted components form at least parts of a communication system and in which case a plurality of printed circuit boards are to be introduced into the housing parallel to one another,
characterized
in that the housing has an edge region forming a frame with the exception of an insertion opening, in that a first printed circuit board (LP1) can be placed on a support which is spaced apart from the rear panel and formed from supporting parts connected to the latter, and can be fixed in a positionally secured manner approximately parallel to the rear panel in this state, in that at least one second printed circuit board (LP2) can be inserted in a freely accessible manner through the insertion opening into the space between the first printed circuit board (LP1) and the rear panel (21), into corresponding retaining and guiding elements (7,8,11,12,9), which are connected integrally to the rear panel and engage in the region of the lateral edge of the printed circuit board.

2. Housing according to Claim 1,
characterized
in that the parts (17,19) of plug connectors, which parts are necessary both for external connections and for the electrical interconnection of the individual printed circuit boards are arranged on the rear edge region - in the insertion direction - of an at least second insertable printed circuit board (LP2) and on that edge region of the inserted and emplaced first printed circuit board (LP1) which is directly adjacent to the former.

3. Housing according to Claim 1,
characterized
in that the supporting parts, with the exception of the insertion opening present for the insertion of the at least second, lower printed circuit board (LP2), are configured indirectly or directly as the frame which concomitantly forms corresponding side walls (2,24) of the housing at the same time.

4. Housing according to Claim 3,
characterized
in that areal parts (2,24,3) of the frame bound, in stepped fashion, an edge region for the printed circuit board (LP1) to be emplaced, the said edge region being matched to the dimensions of the first, upper printed circuit board (LP1).

5. Housing according to Claim 3,
characterized
in that the first printed circuit board (LP1) bears on a web (20) attached to the partial area (2) of the frame.

6. Housing according to one of Claims 3 to 5,
characterized
in that a receptacle for the board edge (22) of one side of the first printed circuit board (LP1) is formed on an edge region of the frame, and a locking element (6) engages automatically in a locking manner on the board edge of at least another side of this first printed circuit board (LP1), for the purpose of reliable fixing, after this printed circuit board has been emplaced.

7. Housing according to Claim 6,
characterized
in that the receptacle comprises a plurality of lugs (13,14), which are fitted on the frame approximately perpendicularly to the board plane and, towards their free end, have an incision, provided with a lead-in bevel, for inserting the board edge region (22).

8. Housing according to Claim 6,
characterized
in that the locking element comprises a resilient web (6), which is displaced during emplacement of the first printed circuit board (LP1) and, once the printed circuit board (LP1) has been emplaced, engages over the board edge in a locking manner by means of its return to its starting position (Figure 7).

9. Housing according to Claim 8,
characterized
in that the resilient web (6) is cut free from a wall part (25) which is perpendicular to the plane of the printed circuit board, and the free end of the said web points in the direction of the support for the first printed circuit board (LP1).

10. Housing according to one of Claims 6 to 9,
characterized
in that, in the region of the locking point, a counter-spring (4,5) engages on the emplaced first printed circuit board (LP1) for the purpose of a lift-off movement.

11. Housing according to Claim 10,
characterized
in that the counter-spring is a resilient web (4), which is cut out from the partial area (2) of the frame (2,24,3) and, in the displaced state, exerts a pressure force on the printed circuit board (LP1) by means of attachment (5) which runs at the free end of the said web, approximately at right angles to the longitudinal axis of the said web, and is directed at this printed circuit board.

12. Housing according to Claim 1,
characterized
in that the guiding elements for the lower, at least second printed circuit board (LP2)to be inserted are formed by webs (7) which are connected to the backplane (21) and have, at least in part, a slot-like receptacle for the printed circuit board edge regions running in the insertion direction, in that a front guiding web (8) - in the insertion direction - defines the end position of the lower printed circuit board (LP2,LP3) to be inserted, in that a locking element (9) fixes the respective lower printed circuit board in a secured manner in the front edge region in the end position of the said printed circuit board.

13. Housing according to Claim 12,
characterized
in that the locking element constitutes a resilient web (9) which is cut free from the backplane (21), is displaced during the insertion of the lower printed circuit board (LP2) and, in the end position of the printed circuit board, fixes this printed circuit board in a secured manner in the end position by means of its return into its starting position.

14. Housing according to Claim 1,
characterized
in that retaining (9) and guiding elements (7,8,11,12) connected to the backplane are arranged in such a way that at least two lower printed circuit boards (LP2,LP3) can be inserted so that they are mounted next to one another.

15. Housing according to Claim 14,
characterized
in that the insertable lower printed circuit boards (LP2,LP3) are used, in terms of their mounted components, for the realization of additional functions that can optionally be used.

16. Housing according to Claims 1 and 2,
characterized
in that the covering hood is formed from a first hood part, which, once it has been put in place, leaves free access to the rear edge region - in the insertion direction of the at least second printed circuit board (LP2) - and also to that edge region of the first printed circuit board (LP1) which is adjacent to the former, and from a second hood part, which covers the said region after it has been put in place.

17. Housing according to one of the preceding claims,
characterized
in that it is used as a wall housing.

18. Housing according to Claim 17,
characterized
in that the locking elements (6,9), both for the first printed circuit board (LP1) and for each of the other printed circuit boards (LP2,LP3), mounted on the backplane, are positioned in such a way that they each engage on the lower edge of the printed circuit board.

19. Housing according to one of the preceding claims,
characterized
in that it is produced as a plastic injection-moulded part including the retaining, guiding and locking elements which are formed integrally on it as constituent parts.

## Revendications

1. Boîtier destiné à loger des plaquettes à circuit imprimé équipées et comportant une zone ouverte accessible susceptible d'être fermée par un capot, notamment pour loger des plaquettes à circuit imprimé dont l'équipement constitue au moins des parties d'un système de communication et plusieurs plaquettes à circuit imprimé devant être installées parallèlement entre elles dans le boîtier,
caractérisé en ce
que le boîtier présente, exception faite d'une ouverture d'introduction, une zone de bord formant un cadre, qu'une première plaquette à circuit imprimé (LP1) peut être posée sur un support espacé de la paroi arrière et formé d'éléments d'appui liés à ladite paroi et qu'ainsi posée, ladite plaquette à circuit imprimé peut être bloquée en position approximativement parallèlement à la paroi arrière, que dans l'espace compris entre la première plaquette à circuit imprimé (LP1) et la paroi arrière (21), au moins une seconde plaquette à circuit imprimé (LP2) peut être introduite par l'ouverture d'introduction dans des éléments de fixation et de guidage (7, 8, 11, 12, 9) appropriés qui sont reliés d'un seul tenant à la paroi arrière et agissent dans la région du bord latéral de la plaquette à circuit imprimé, celle-ci étant librement accessible.

2. Boîtier selon la revendication 1,
caractérisé en ce
que les éléments (17, 19) de connecteurs nécessaires aussi bien aux raccordements externes qu'à la connexion électrique des différentes plaquettes à circuit imprimé entre elles sont disposés dans la zone de bord, arrière dans la direction d'introduction, d'une seconde plaquette à circuit imprimé (LP2) introduite au nombre d'au moins une et sur la zone de bord directement voisine de la première plaquette à circuit imprimé (LP1) posée.

3. Boîtier selon la revendication 1,
caractérisé en ce
que les éléments d'appui, à l'exception de l'ouverture prévue pour l'introduction de la seconde plaquette à circuit imprimé (LP2) inférieure, au nombre d'au moins une, sont réalisés directement ou indirectement sous la forme du cadre qui forme simultanément des parois latérales (2, 24) correspondantes du boîtier.

4. Boîtier selon la revendication 3,
caractérisé en ce
que les parties de surface (2, 24, 3) du cadre délimitent de manière étagée une zone de bord qui est adaptée aux dimensions de la première plaquette à circuit imprimé (LP1) supérieure à poser.

5. Boîtier selon la revendication 3,
caractérisé en ce
que la première plaquette à circuit imprimé (LP1) repose sur une nervure (20) rapportée sur la surface partielle (2) du cadre.

6. Boîtier selon une des revendications 3 à 5,
caractérisé en ce
que sur une zone de bord du cadre, il est prévu un logement pour le bord (22) d'un côté de la première plaquette à circuit imprimé (LP1) et qu'une fois que cette plaquette à circuit imprimé est posée, un élément de verrouillage (6), en vue de réaliser une fixation sûre, se verrouille automatiquement sur le bord d'au moins un autre côté de cette première plaquette à circuit imprimé (LP1).

7. Boîtier selon la revendication 6,
caractérisé en ce
que le logement est formé de plusieurs ergots (13, 14) montés sur le cadre, approximativement perpendiculairement au plan de la plaquette, lesquels ergots présentent, en direction de l'extrémité libre, une découpe pourvue d'un biseau de guidage pour introduire la zone de bord (22) de la plaquette.

8. Boîtier selon la revendication 6,
caractérisé en ce
que l'élément de verrouillage est constitué d'une barrette (6) élastique qui est écartée lors de la mise en place de la première plaquette à circuit imprimé (LP1) et qui, une fois la plaquette à circuit imprimé (LP1) mise en place, revient dans sa position initiale et passe par-dessus le bord de la plaquette pour le bloquer (figure 7).

9. Boîtier selon la revendication 8,
caractérisé en ce
que la barrette élastique (6) est découpée dans une partie de paroi (25) perpendiculaire au plan de la plaquette à circuit imprimé et est dirigée par son extrémité libre en direction de l'appui pour la première plaquette à circuit imprimé (LP1).

10. Boîtier selon l'une des revendications 6 à 9,
caractérisé en ce
qu'un ressort conjugué (4, 5) agit dans la région du point de verrouillage, sur la première plaquette à circuit imprimé (LP1) posée, tendant ainsi à soulever ladite plaquette.

11. Boîtier selon la revendication 10,
caractérisé en ce
que le ressort conjugué est une barrette (4) élastique dégagée par découpage dans la surface partielle (2) du cadre (2, 24, 3), laquelle barrette exerce, lorsqu'elle est écartée, une pression sur la plaquette à circuit imprimé (LP1) par une saillie (5) qui à son extrémité libre fait approximativement un angle droit avec l'axe longitudinal de ladite barrette et est dirigée vers cette plaquette à circuit imprimé.

12. Boîtier selon la revendication 11,
caractérisé en ce
que les éléments de guidage pour la seconde plaquette à circuit imprimé (LP2) inférieure à introduire au nombre d'au moins une sont formés par des nervures (7) qui sont reliées à la plaque formant la paroi arrière (21) et présentent au moins en partie un logement en forme de fente pour les zones de bord de plaquette à circuit imprimé s'étendant dans la direction d'introduction, qu'une nervure de guidage (8) avant dans la direction d'introduction définit la position terminale de la plaquette à circuit imprimé (LP2, LP3) inférieure à introduire et qu'un élément de verrouillage (9) bloque la plaquette à circuit imprimé inférieure dans la zone de bord avant, lorsque ladite plaquette à circuit imprimé est dans sa position terminale.

13. Boîtier selon la revendication 12,
caractérisé en ce que l'élément de verrouillage constitue une barrette (9) élastique découpée dans la plaque formant la paroi arrière (21), laquelle barrette est écartée lors de l'introduction de la plaquette à circuit imprimé (LP2) inférieure puis, lorsque la plaquette à circuit imprimé est dans sa position terminale, revient dans sa position de départ pour bloquer cette plaquette à circuit imprimé dans la position terminale.

14. Boîtier selon la revendication 1,
caractérisé en ce
que des éléments de fixation (9) et de guidage (7, 8, 11, 12) reliés à la plaque formant la paroi arrière sont disposés de telle manière qu'au moins deux plaquettes à circuit imprimé (LP2, LP3) inférieures peuvent être introduites pour être mises en place côte à côte.

15. Boîtier selon la revendication 14,
caractérisé en ce
que les plaquettes à circuit imprimé (LP2, LP3) inférieures pouvant être introduites sont utilisées avec leur équipement pour réaliser des fonctions supplémentaires optionnelles.

16. Boîtier selon les revendications 1 et 2,
caractérisé en ce
que le capot est formé d'une première partie qui, lorsqu'elle est montée, laisse libre accès à la zone de bord arrière dans la direction d'introduction de la seconde plaquette à circuit imprimé (LP2), au nombre d'au moins une, et à la zone de bord voisine de la première plaquette à circuit imprimé (LP1), et d'une seconde partie qui, une fois mise en place, recouvre cette zone mentionnée.

17. Boîtier selon l'une des revendications précédentes,
caractérisé en ce
qu'il est utilisé comme boîtier mural.

18. Boîtier selon la revendication 17,
caractérisé en ce
que les éléments de verrouillage (6, 9), pour la première plaquette à circuit imprimé (LP1) de même que pour chacune des autres plaquettes à circuit imprimé (LP2, LP3) montées sur la plaque formant la paroi arrière, sont positionnés de telle manière qu'ils agissent sur le bord de plaquette à circuit imprimé inférieur.

19. Boîtier selon l'une des revendications précédentes,
caractérisé en ce
qu'il est fabriqué sous forme de pièce en matière plastique moulée par injection, y compris les éléments de fixation, de guidage et de verrouillage qui sont des éléments réalisés d'un seul tenant avec le boîtier.
